(19) Europäisches Patentamt
European Patent Office
Office européen des brevets

(11) **EP 4 198 830 A1**

(12) **EUROPEAN PATENT APPLICATION**

(43) Date of publication:
**21.06.2023 Bulletin 2023/25**

(21) Application number: **22213165.8**

(22) Date of filing: **13.12.2022**

(51) International Patent Classification (IPC):
***G06N 3/065*** (2023.01)

(52) Cooperative Patent Classification (CPC):
**G06N 3/065; G11C 7/1006; G11C 11/221;
G11C 11/223; G11C 11/2259; G11C 11/2275;
G11C 11/54**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **15.12.2021 KR 20210179966**

(71) Applicant: **Samsung Electronics Co., Ltd.
Gyeonggi-do 16677 (KR)**

(72) Inventors:
• **MOON, Taehwan
  Suwon-si, 16678 (KR)**
• **HEO, Jinseong
  Suwon-si, 16678 (KR)**
• **NAM, Seunggeol
  Suwon-si, 16678 (KR)**
• **BAE, Hagyoul
  Suwon-si, 16678 (KR)**
• **LEE, Hyunjae
  Suwon-si, 16678 (KR)**

(74) Representative: **Elkington and Fife LLP
Prospect House
8 Pembroke Road
Sevenoaks, Kent TN13 1XR (GB)**

(54) **NEURAL NETWORK DEVICE AND ELECTRONIC SYSTEM INCLUDING THE SAME**

(57) Provided is a neural network device including a plurality of word lines extending in a first direction, a plurality of bit lines extending in a second direction intersecting the first direction, and a plurality of memory cells arranged at points where the plurality of word lines and the plurality of bit lines intersect one another. Each of the plurality of memory cells includes at least two ferroelectric memories connected in parallel along a word line corresponding to each of the plurality of memory cells.

FIG. 2

**Description**

FIELD OF THE INVENTION

The present disclosure relates to neural network devices and electronic systems including the same.

BACKGROUND OF THE INVENTION

Interest in neuromorphic processors that perform neural network operations has increased. For example, research on a neuromorphic processor including a neuron circuit and a synaptic circuit has been conducted. Such neuromorphic processors can be used in neural network devices for driving various neural networks such as convolutional neural networks (CNN), recurrent neural networks (RNN), feedforward neural networks (FNN), etc. and can be used in fields including data classification, image recognition, autonomous control, speak recognition, etc.

SUMMARY OF THE INVENTION

Provided are neural network devices and electronic systems including the same. The technical objectives to be achieved by the present disclosure are not limited to the technical objectives as described above or below, and other technical objectives may be inferred from the following embodiments.

Additional aspects will be set forth in part in the description which follows and, in part, will be apparent from the description, or may be learned by practice of the presented embodiments of the disclosure.

According to an aspect of an embodiment, a neural network device includes a plurality of word lines extending in a first direction, a plurality of bit lines extending in a second direction intersecting the first direction, and a plurality of memory cells at points where the plurality of word lines and the plurality of bit lines intersect, wherein each of the plurality of memory cells comprises at least two ferroelectric memories connected in parallel along a corresponding word line of the plurality of word lines.

According to another aspect of an embodiment, an electronic system includes the neural network device described above, a non-transitory memory, and a processor configured to control a function of the neural network device by executing programs stored in the memory, wherein the neural network device performs a neural network operation based on input data received from the processor and generates an information signal corresponding to the input data based on a result of the neural network operation.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a view for describing an architecture of a neural network according to at least one embodiment;
FIG. 2 is a view for describing an arithmetic operation performed in a neural network according to at least one embodiment;
FIG. 3 is a view illustrating an in-memory computing circuit according to at least one embodiment;
FIG. 4 is a view illustrating a configuration of a neural network device according to at least one embodiment;
FIG. 5 is a view illustrating a circuit structure during training of a neural network device according to at least one embodiment;
FIG. 6 is a view for describing a principle in which each memory cell of a neural network device according to at least one embodiment has linear state-change characteristics;
FIG. 7 is a view for describing a method of determining different voltages applied to ferroelectric memories included in each memory cell of a neural network device according to at least one embodiment;
FIG. 8 is a view for describing incremental step pulse programming (ISPP) according to at least one embodiment;
FIG. 9 is a view for illustrating a comparison between a potentiation and depression (PD) characteristic curve of a single ferroelectric memory and a PD characteristic curve of a memory cell, according to at least one embodiment;
FIG. 10 is a view illustrating a circuit structure at the time of inference of a neural network device according to at least one embodiment; and
FIG. 11 is a block diagram illustrating a configuration of an electronic system according to at least one embodiment.

DETAILED DESCRIPTION

Reference will now be made in detail to some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terms used in the embodiments are selected from general terms that are currently widely used as possible while considering the functions in the embodiments. However, the terms may vary depending on the intention or precedent of those skilled in the art, the emergence of new technologies, etc. In addition, in a specific case, there are terms that are arbitrarily selected, and in this case, the meaning of the terms will be described in detail in the description of the embodiment. Therefore, the terms used in the present embodiments are not simple names, but it should be defined based on the meaning of the terms and the contents of the present embodiments.

In the descriptions of the embodiments, when a part is connected to another part, this is not only a case that is directly connected, but also a case that is electrically connected with another component therebetween. It will be understood that when a portion includes a component, it does not exclude other components, but may further include other components, unless otherwise stated.

It should not be construed that the terms "consisting of" or "comprising" used herein are meant to include all of various components and steps described in the specification, and it should be construed that some components or some steps may not be included, and/or additional components or steps may be further included.

It will be understood that although the terms "first," "second," etc., may be used herein to describe various components, these components should not be limited by these terms. The terms are only used to distinguish one component from another.

The description of the following embodiments should not be construed as limiting the scope of the rights, and what those skilled in the art can easily infer should be construed as belonging to the scope of the embodiments. Hereinafter, embodiments for illustration only will be described in detail with reference to the accompanying drawings.

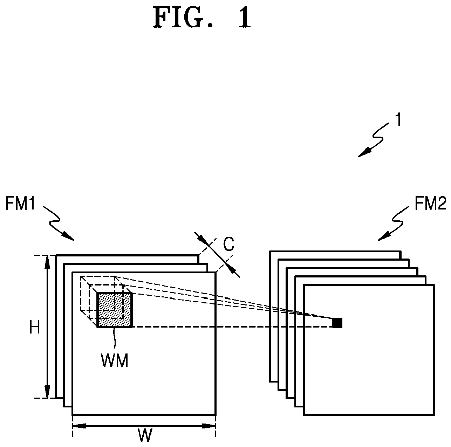

FIG. 1 is a view for describing an architecture of a neural network according to at least one embodiment.

Referring to FIG. 1, a neural network 1 may be expressed as a model using nodes and edges. The model may be, for example, a mathematic model, a digital model, an analog model, and/or a combination thereof. The neural network 1 may be an architecture of a deep neural network (DNN) and/or n-layers neural networks. The DNN and/or n-layers neural networks may correspond to convolutional neural networks (CNN), recurrent neural networks (RNN), deep belief networks, restricted Boltzmann machines, and/or the like. For example, the neural network 1 may be implemented with the convolutional neural networks (CNN). However, the example embodiments are not limited thereto. The neural network 1 of FIG. 1 may correspond to some layers of the CNN. Thus, the neural network 1 may correspond to a convolution layer, a pooling layer, a fully connected layer, and/or the like of the CNN. Hereinafter, for convenience, the description of the neural network 1 corresponds to the convolution layer of the CNN.

In the convolution layer, a first feature map FM1 may correspond to an input feature map, and the second feature map FM2 may correspond to an output feature map. The feature map may mean and/or represent a data set in which various features of input data are expressed. The first and second feature maps FM1 and FM2 may be a high-dimensional matrix of two or more dimensions and have respective activation parameters. The feature maps FM1 and FM2 may correspond to three-dimensional feature maps (for example, the feature maps FM1 and FM2 may have a width W (or referred to as a column), a height (or referred to as a row), and a depth C). In these cases, the depth C may correspond to the number of channels in the corresponding feature map.

In the convolution layer, a convolution operation may be performed on the first feature map FM1 and a weight map WM. As a result, the second feature map FM2 may be generated. The weight map WM may filter the first feature map FM1 and may also be referred to as a weight filter and/or weight kernel. In an example, the depth of the weight map WM (e.g., the number of channels of the weight map WM) may be the same as the depth of the first feature map FM1 (e.g., the number of channels of the first feature map FM1). The weight map WM may be shifted to traverse the first feature map FM1 as a sliding window. During each shift, each of weights included in the weight map WM may be multiplied and added to all feature values in an area overlapping the first feature map FM1. As the first feature map FM1 and the weight map WM are convoluted, one channel of the second feature map FM2 may be generated.

Although one weight map WM is indicated in FIG. 1, substantially, a plurality of weight maps may be convoluted with the first feature map FM1 so that a plurality of channels of the second feature map FM2 may be generated. The second feature map FM2 of the convolution layer may be an input feature map of a next layer. For example, the second feature map FM2 may be an input feature map of a pooling layer. However, the example embodiments are not limited thereto.

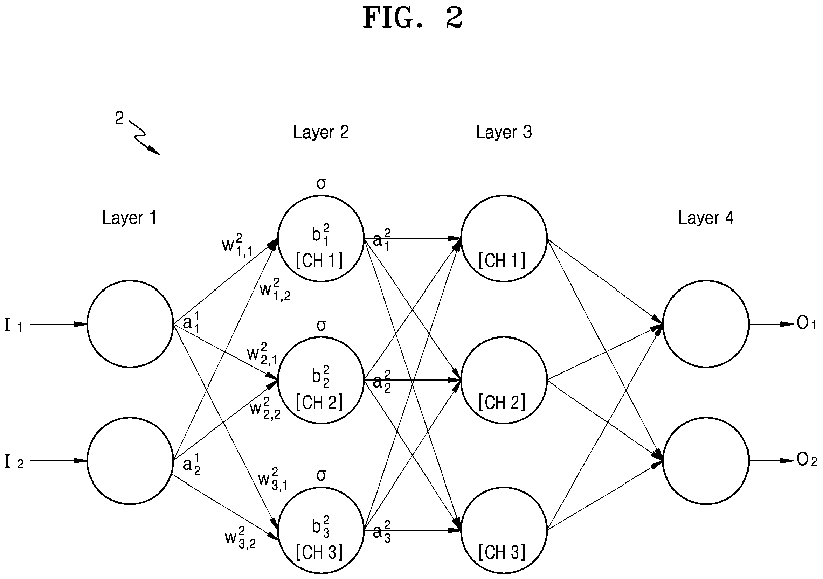

FIG. 2 is a view for describing an arithmetic operation performed in a neural network according to at least one embodiment.

Referring to FIG. 2, a neural network 2 may have a structure including an input layer, hidden layers, and an output layer, which may perform an arithmetic operation based on received input data (for example, $I_1$ and $I_2$) and may generate output data (for example, $O_1$ and $O_2$) based on the result of performing the arithmetic operation.

In some example embodiments, the neural network 2 may be a DNN and/or n-layers neural networks including two or more hidden layers, as described above. For example, as shown in FIG. 2, the neural network 2 may be a DNN including an input layer Layer 1, two (or more) hidden layers Layer 2 and Layer 3, and an output layer Layer 4. When the neural network 2 is implemented with a DNN architecture, the neural network 2 may include more layers configured to (and/or capable of) processing valid information. Thus, the neural network 2 may process more complicated data sets than a neural network having a single layer. Also, although the neural network 2 includes four layers, this is just an example, and the neural network 2 may include less or more layers and/or less or more channels. That is, the neural network 2 may include layers having various structures different from those shown in FIG. 2.

Each of the layers included in the neural network 2 may include a plurality of channels. The plurality of channels may correspond to a plurality of artificial nodes, known as neurons, processing elements (PEs), units, and/or similar terms. For example, as shown in FIG. 2, Layer 1 may include two channels (nodes), and each of Layer 2 and Layer 3 may include three channels. Also, this is just an example, and each of the layers included in the neural network 2 may include different numbers of channels (nodes).

The channels included in each of the layers of the neural network 2 may be connected to one another to process data. For example, one channel may receive data from other channels to perform an arithmetic operation and/or to output the result of the arithmetic operation to other channels.

Each of an input and an output of each of the channels may be referred to as an input activation and an output activation. For example, the activation may be an output of one channel and/or, a parameter corresponding to an input of channels included in the next layer. Also, each of the channels may determine its own activation based on activations received from channels included in the previous layer and weights. The weight may represent a parameter used to calculate an output activation at each channel, and may be a value allocated to a connection relationship between the channels.

Each of the channels may be processed by a computational unit and/or processing element for outputting an output activation by receiving an input, and an input-output of each of the channels may be mapped.

For example, when σ is an activation function, $w_{jk}^i$ is a weight from a k-th channel included in an (i-1)-th layer to a j-th channel included in an i-th layer, $b_j^i$ is a bias of the j-th channel included in the i-th layer and $a_j^i$ is an activation of the j-th channel included in the i-th layer, the activation $a_j^i$ may be calculated using equation 1 below.

[Equation 1]

$$a_j^i = \sigma\left(\sum_k (w_{jk}^i \times a_k^{i-1}) + b_j^i\right)$$

As shown in FIG. 2, an activation of a first channel CH1 of a second layer 2 2 Layer 2 may be expressed as $a_1^2$. Accordingly, $a_1^2$ may have a value of $a_1^2 = \sigma(w_{1,1}^2 \times a_1^1 + w_{1,2}^2 \times a_2^1 + b_1^2)$ according to equation 1. The activation function σ may be a rectified linear unit (ReLU). However, embodiments are not limited thereto. For example, the activation function σ may be Sigmoid, hyperbolic tangent tanh, Maxout, and/or the like.

As described above, in the neural network 2, numerous data sets may be exchanged between a plurality of channels interconnected, and an arithmetic operation process may be performed while passing through layers. In the computation process, numerous multiply-accumulate (MAC) operations may be performed, and numerous memory access operations for loading an activation and a weight to be calculated of the MAC operation at an appropriate time need to be performed together.

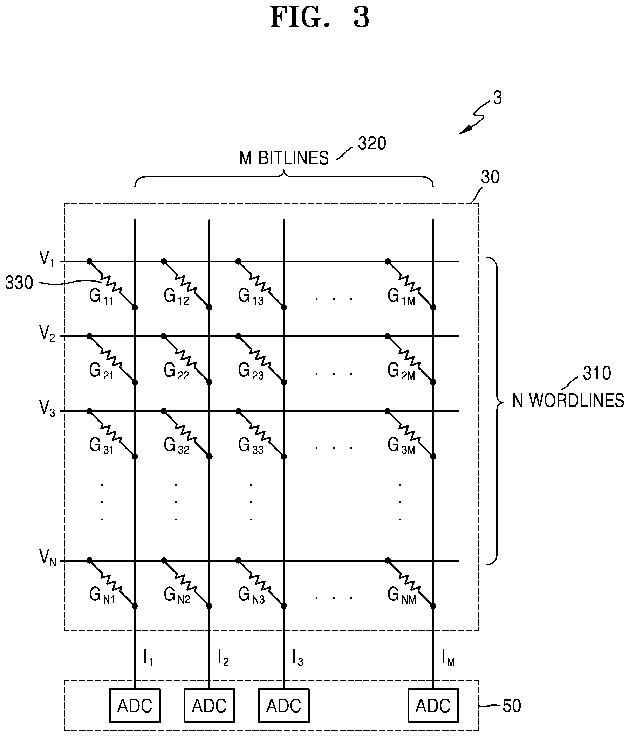

Also, in a general digital computer, a computational unit and memory are separated from each other, and a Von Neumann structure including a common data bus for data transmission between two separated blocks may be used. Thus, in the process of implementing the neural network 2 in which data movement and operations are continuously repeated, a lot of time may be required for data transmission, and excessive power may be consumed. In order to solve these problems, an in-memory computing circuit has been proposed as an architecture that integrates the memory and the computational unit for performing the MAC operation. Hereinafter, the in-memory computing circuit will be described in more detail with reference to FIG. 3.

FIG. 3 is a view illustrating an in-memory computing circuit according to at least one embodiment.

Referring to FIG. 3, an in-memory computing circuit 3 may include an analog crossbar array 30 and an analog to digital converter (ADC) 50. In the in-memory computing circuit 3 shown in FIG. 3, only components related to the present embodiments are shown for convenience of description. Thus, it is obvious to those skilled in the art that the in-memory computing circuit 3 may further include other general-purpose components than the components shown in FIG. 3. For example, the in-memory computing circuit 3 may include (and/or be connected to) processing circuitry, such hardware, software, or the combination of hardware and software, configured to control signals input into the in-memory computing circuit 3. The processing circuitry may include, but is not limited to, a processor, a Central Processing Unit (CPU), a controller, an Arithmetic Logic Unit (ALU), a digital signal processor, a microcomputer, a Field Programmable Gate Array (FPGA), a System-on-Chip (SoC), a programmable logic unit, a microprocessor, Application-specific Integrated Circuit (ASIC), semiconductor elements in an integrated circuit, circuits enrolled as an Intellectual Property (IP), electrical components (such as at least one of transistors, resistors, capacitors, electrical components such as logic gates including at least one of AND gates, OR gates, NOR gates, NAND gates, NOT gates, XOR gates, and/or the like), etc. In some example embodiments, the processing circuitry may include computer-readable program code stored in a computer-readable medium. The computer-readable program code may be provided to a variety of computers and/or processors of data processing devices. The computer readable media may be, for example, a non-transitory computer readable media. The term "non-transitory," as used herein, is a description of the medium itself (e.g., as tangible, and not a signal) as opposed to a limitation on data storage persistency (e.g., RAM vs. ROM). For example, the in-memory computing circuit 3 may include (and/or be connected to) a voltage (or current) generator and/or an electronic controller configured to control the timing, magnitude, and/or the like of signals input into the in-memory computing circuit 3.

The analog crossbar array 30 may include a plurality of word lines 310, a plurality of bit lines 320, and a plurality of memory cells 330. In at least one example, when the in-memory computing circuit 3 is used to implement a neuromorphic processor, the plurality of word lines 310 may correspond to lines for receiving an input from a presynaptic neuron circuit, and the plurality of bit lines 320 may correspond to lines for transmitting an output to postsynaptic neurons. In addition, the plurality of memory cells 330 may correspond to synapse circuits for storing information about connection intensity between the presynaptic neuron circuit and the postsynaptic neurons.

The plurality of word lines 310 may be used to receive input data. For example, when the number of the plurality of word lines 310 is N (where N represents a natural number), voltages $V_1$, $V_2$, ..., and $V_N$, corresponding to input activations, may be applied to N word lines. The plurality of bit lines 320 may intersect the plurality of word lines 310. For example, when the number of the plurality of bit lines 320 is M (where M represents a natural number), the plurality of bit lines 320 and the plurality of word lines 310 may intersect one another at intersecting points of N x M.

Also, the plurality of memory cells 330 may be arranged at the intersecting points of the plurality of word lines 310 and the plurality of bit lines 320. Each of the plurality of memory cells 330 may be implemented with non-volatile memory for storing weights. However, embodiments are not limited thereto, and each of the plurality of memory cells 330 may be volatile memory.

In the example shown in FIG. 3, because the plurality of memory cells 330 have conductances $G_{11}$, ..., and $G_{NM}$ corresponding to the weights, when a voltage corresponding to an input activation may be applied to each of the plurality of word lines 310, a current having the magnitude of I = V x G according to the Ohm's rule may be output to the memory cell 330. Since currents output from memory cells arranged along one bit line are combined with each other, a current sum $I_1$, ..., and $I_M$ may be output along the plurality of bit lines 320. The current sum $I_1$, ..., and $I_M$ may correspond to the result of a MAC operation performed in an analog manner. In at least one example, the weights of the analog crossbar array 30 may be presented by values in an N x M matrix.

The ADC 50 may convert the result (e.g., the current sum $I_1$, ..., and $I_M$) of the analog MAC operation output from the analog crossbar array 30 into a digital signal. The result of the MAC operation converted into the digital signal may be output from the ADC 50 and may be used in a procedure of a subsequent neural network operation.

In FIG. 3, a memory cell is shown as a resistance element. However, the memory cell may be implemented with various elements. In the related art, as the memory cell includes a transistor and a capacitor, excellent multi-level characteristics, linearity, and reliability may be secured, however, a relatively large area and power consumption are required. Thus, non-volatile memory having a simple structure for replacing an existing memory cell has been proposed, and ferroelectric memory is a representative example thereof. Because the ferroelectric memory has a small switching energy, the ferroelectric memory may be operated with low voltage and low power, and an operation repetition life of the ferroelectric memory is long. However, in the ferroelectric memory, ferroelectric switching occurs rapidly only in the vicinity of a coercive voltage, so it may be difficult to derive a linear state-change.

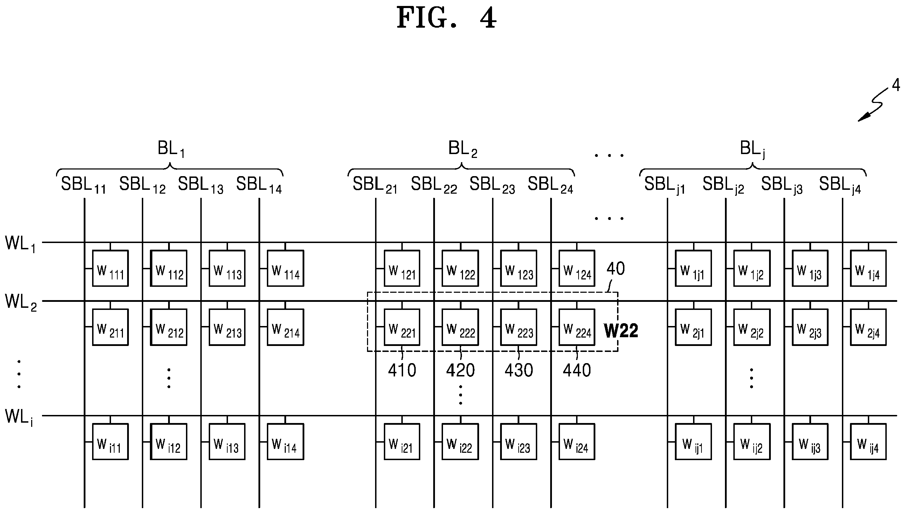

In the neural network device according to the present disclosure, the resistance (or conductance) of the memory cell may be derived to be changed linearly with respect to the voltage applied to the memory cell while the ferroelectric memory is used to implement the memory cell. Hereinafter, a neural network device according to the present disclosure will be described in detail with reference to FIGS. 4 through 9.

FIG. 4 is a view illustrating the configuration of a neural network device according to at least one embodiment.

Referring to FIG. 4, a neural network device 4 may include a plurality of word lines $WL_1$, $WL_2$, ..., and $WL_i$, a plurality of bit lines $BL_1$, $BL_2$, ..., and $BL_j$, and a plurality of memory cells 40 (where i and j represent natural numbers). In FIG. 4, reference numeral 40 is notified only for a memory cell disposed at an intersecting point of the word line $WL_2$ and the bit line $BL_2$ for simplicity, but the same description may be applied to memory cells disposed at other intersecting points.

The plurality of word lines $WL_1$, $WL_2$, ..., and $WL_i$ may extend in a first direction, and the plurality of bit lines $BL_1$, $BL_2$, ..., and $BL_j$ may extend in a second direction intersecting the first direction. In FIG. 4, the first direction is a horizontal direction, and the second direction is a vertical direction, but this is just an illustrative example; and the first direction and the second direction may be otherwise set as appropriate directions intersecting each other. Also, the term "intersect" does not necessarily mean that two directions are perpendicular to each other but includes all cases where two directions meet at points.

The plurality of memory cells 40 may be disposed at points where a plurality of word lines $WL_1$, $WL_2$, ..., and $WL_i$ and a plurality of bit lines $BL_1$, $BL_2$, ..., and $BL_j$ intersect. Because the number of the plurality of word lines $WL_1$, $WL_2$, ..., and $WL_i$ is i and the number of the plurality of bit lines $BL_1$, $BL_2$, ..., and $BL_j$ is j, the number of the plurality of memory cells 40 may be i X j. Each of the plurality of memory cells 40 may include at least two ferroelectric memories connected in parallel along a word line corresponding to each of the plurality of memory cells 40.

For example, as shown in FIG. 4, the memory cells 40 may include four ferroelectric memories 410, 420, 430, and 440. However, FIG. 4 is just a one example, and the memory cell 40 may include an appropriate number of ferroelectric memories, e.g., when there are at least two memory cells 40.

Also, each of the plurality of bit lines $BL_1$, $BL_2$, ..., and $BL_j$ may include sub-bit lines respectively connected to ferroelectric memories included in one memory cell among memory cells connected to each bit line. For example, a bit line may include an appropriate number of sub-bit lines such that the number of sub-bit lines corresponds to the number of ferroelectric memories. In the example illustrated in FIG. 4, a bit line $BL_2$ may include four sub-bit lines $SBL_{21}$, $SBL_{22}$, ..., and $SBL_{24}$, and the sub-bit lines $SBL_{21}$, $SBL_{22}$, ..., and $SBL_{24}$ may be respectively connected to ferroelectric memories 410, 420, 430, and 440 included in the memory cell 40. However, FIG. 4 is just a one example, and the number of sub-bit lines included in each bit line $BL_1$, $BL_2$, ..., and $BL_j$ may be one, two, or more.

For example, in FIG. 4, the sub-bit lines $SBL_{21}$, $SBL_{22}$, ..., and $SBL_{24}$ are independent lines. However, the sub-bit lines $SBL_{21}$, $SBL_{22}$, ..., and $SBL_{24}$ may be connected to each other at an input terminal to form a single path. However, applying a certain voltage to a single path formed as input terminals of the sub-bit lines $SBL_{21}$, $SBL_{22}$, ..., and $SBL_{24}$ connected to each other, may be substantially the same as applying the same voltage to each of the independent sub-bit lines $SBL_{21}$, $SBL_{22}$, ..., and $SBL_{24}$. Both cases may be expressed as applying a voltage to the input terminal of the bit line $BL_2$. In the example of FIG. 4, an upper end of the bit line may be referred to as an input terminal, and a lower end of the bit line may be referred to as an output terminal.

Each of the ferroelectric memories 410, 420, 430, and 440 may include at least one capacitor having a metal-ferroelectric-metal structure, a ferroelectric tunnel junction (FTJ) element, and a ferroelectric field-effect transistor (FeFET); but embodiments are not necessarily limited thereto. All the ferroelectric memories 410, 420, 430, and 440 may include the same and/or different type of elements.

Each of the plurality of memory cells 40 may further include a selection element for selectively approaching the memories 410, 420, 430, and 440 included in each of the plurality of memory cells 40. Thus, at least some of the plurality of memory cells 40 may be selected, and at least some of the ferroelectric memories included in the selected memory cells may be selected. For example, a memory cell arranged at an intersecting point of the word line $WL_2$ and the bit line $BL_2$ among the plurality of memory cells 40 may be selected by the selection element, and an access to ferroelectric memories included in the memory cell may be allowed.

For example, each of the plurality of memory cells 40 may include a transistor, a threshold switch, and/or the like, which is connected in series to each of the ferroelectric memories 410, 420, 430, and 440. However, embodiments are not limited thereto, and each of the plurality of memory cells 40 may include an element that enables optional access to the ferroelectric memories 410, 420, 430 and 440.

When the selection element is a transistor, a word line may be connected to a gate terminal of the transistor, and a ferroelectric memory connected to the transistor may be selected by a voltage applied through the word line. However, the example embodiments are not limited thereto, and a separate control line may also be connected to the gate terminal of the transistor. The transistor may be a metal oxide semiconductor (MOS) transistor, a bipolar transistor, and/or the like, but the example embodiments are not limited thereto.

The threshold switch is an element allowing the flow of a current only when a difference between voltages applied to both ends of the threshold switch is equal to or greater than a threshold value and which may perform a similar operation to the transistor. For example, the threshold switch may control an access to a ferroelectric memory connected to the threshold switch based on a difference between a voltage applied to an input terminal of a word line and a voltage applied to an output terminal of a bit line.

Each of the ferroelectric memories 410, 420, 430, and 400 has a conductance (or resistance). The conductance may correspond to a weight indicating connection intensity between a presynaptic neuron circuit connected to an input terminal of the word line and a postsynaptic neuron circuit connected to an output terminal of the bit line. For example, the ferroelectric memories 410, 420, 430, and 440 included in the memory cell arranged at an intersecting point of the word line $WL_2$ and the bit line $BL_2$ may have conductances correspond-

ing to weights $w_{221}$, $w_{222}$, $w_{223}$, and $w_{224}$, respectively.

A synthesis conductance of the ferroelectric memories 410, 420, 430, and 440 included in each of the plurality of memory cells 40 may correspond to a weight stored in each of the plurality of memory cells 40. For example, a synthesis conductance

$$W_{22}\left(=\sum_{k=1}^{k=4} w_{22k}\right)$$

of the ferroelectric memories 410, 420, 430, and 440 included in the memory cell 40 arranged at the intersecting point of the word line $WL_2$ and the bit line $BL_2$ may correspond to the weight stored in the corresponding memory cell 40.

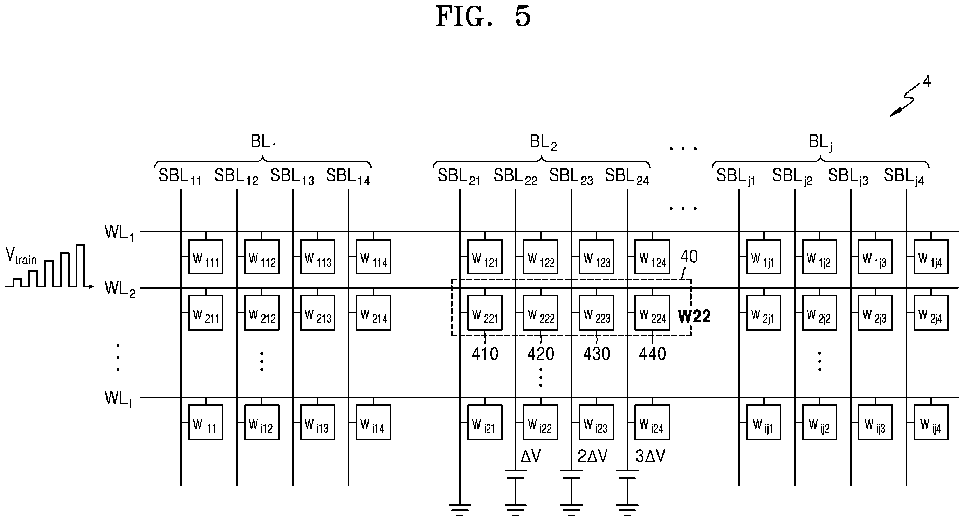

The weight stored in each of the plurality of memory cells 40 may be linearly updated. Linearly updating of the weight stored in each of the plurality of memory cells 40 means that the conductance of each of the plurality of memory cells 40 is linearly changed in proportional to the magnitude of the voltage applied to each of the plurality of memory cells 40. For example, the linear change may provide more precise and/or accurate updates to the memory cells compared to memory cells including a single ferroelectric memory, which have nonlinear state-change characteristics. A reason for which the memory cell 40 included in the neural network device 4 according to the present disclosure may have linear state-change characteristics, will be described in further detail with reference to FIGS. 5 through 7.

FIG. 5 is a view illustrating a circuit structure during training of a neural network device according to at least one embodiment.

Referring to FIG. 5, an example of a process of updating a weight $W_{22}$ of the memory cell 40 arranged at the intersecting point of the word line $WL_2$ and the bit line $BL_2$ based on a voltage $V_{train}$ input through the word line $WL_2$ is shown.

The neural network device 4 may apply different voltages to the ferroelectric memories 410, 420, 430, and 440 included in each of the plurality of memory cells 40 in the process of updating the weight stored in each of the plurality of memory cells 40 so as to train the neural network implemented by the neural network device 4.

For example, as shown in FIG. 5, the neural network device 4 may apply direct current (DC) voltages having a constant voltage interval to output terminals of sub-bit lines $SBL_{21}$, $SBL_{22}$, ..., and $SBL_{24}$ in the process of updating the weight. Because a ground voltage is connected to an output terminal of the sub-bit line $SBL_{21}$, $V_{train}$ may be applied to the ferroelectric memory 410 connected to the sub-bit line $SBL_{21}$. Also, because a voltage $\Delta V$ is connected to the output terminal of the sub-bit line $SBL_{22}$, $V_{train}-\Delta V$ may be applied to the ferroelectric memory 420 connected to the sub-bit line $SBL_{22}$. In the same manner, $V_{train}-2\Delta V$ and $V_{train}-3\Delta V$ may be applied to the ferroelectric memory 430 and the ferroelectric memory 440, respectively.

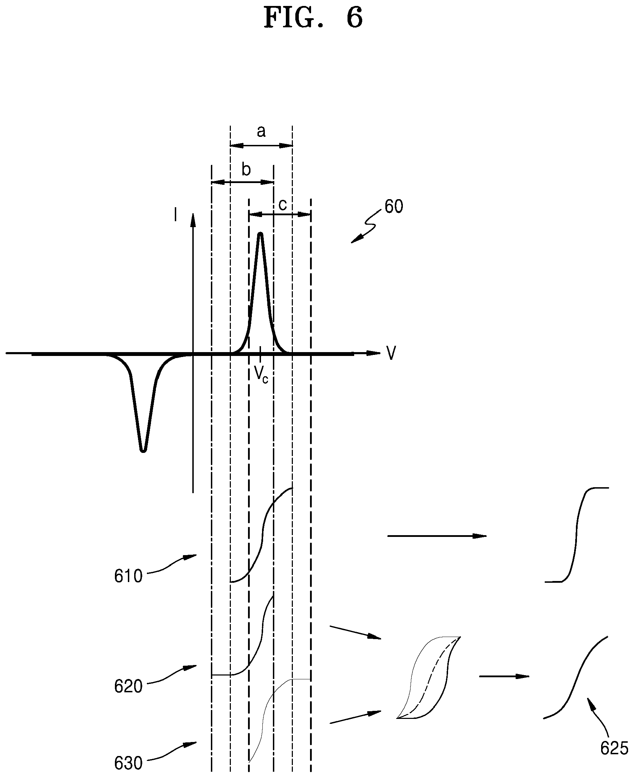

In this way, different voltages may be applied to the ferroelectric memories 410, 420, 430, and 440 connected in parallel. In the neural network device 4 according to the present disclosure, the ferroelectric memories 410, 420, 430, and 440 connected in parallel may constitute one memory cell 40, and different voltages may be applied to the ferroelectric memories 410, 420, 430, and 440 during training (programming) so that linearity of the weight stored in the memory cell 40 may be secured. The reasons for securing the linearity of the weight by the above-described training method will be described in detail with reference to FIG. 6.

FIG. 6 is a view for describing a principle in which each memory cell of a neural network device according to at least one embodiment has linear state-change characteristics.

Referring to FIG. 6, a voltage-current characteristic curve 60 indicating switching characteristics of a ferroelectric memory is shown. Referring to a positive voltage portion of the voltage-current characteristic curve 60, when the voltage applied to the ferroelectric memory is gradually increased from 0, a rapid change in conductance may occur only near a coercive voltage Vc. For example, because ferroelectric switching occurs in a voltage range corresponding to a section a, the conductance of the ferroelectric memory greatly changes in the section a.

Conductance changes in the ferroelectric memory corresponding to the section a of the voltage-current characteristic curve 60 may be represented by a potentiation and depression (PD) curve 610, and conductance changes in the ferroelectric memory corresponding to a section b of the voltage-current characteristic curve 60 may be represented by a PD curve 620, and conductance changes in the ferroelectric memory corresponding to a section c of the voltage-current characteristic curve 60 may be represented by a PD curve 630. All of the PD curve 610, the PD curve 620, and the PD curve 630 may have nonlinear characteristics with respect to voltage.

However, a case where a ferroelectric memory following the PD curve 620 and a ferroelectric memory following the PD curve 630 are connected in parallel, is illustrated. When two ferroelectric memories are the same elements, the conductance of one ferroelectric memory following the PD curve 620 corresponding to the section b and the conductance of another ferroelectric memory following the PD curve 630 corresponding to the section c mean that different voltages are applied to two ferroelectric memories during training. The synthesis conductance of two ferroelectric memories connected in parallel may correspond to a PD curve 625 that is a result of normalizing and combining the PD curve 620 and the PD curve 630. Comparing the PD curve 610 with the PD curve 625, the PD curve 625 may be more linear with respect to voltage changes.

As described above, even if each ferroelectric memory has nonlinear state-change characteristics, when a plurality of ferroelectric memories are connected to each other in parallel, to configure one memory cell, and state changes are derived by applying different voltages to the parallel-connected ferroelectric memories, a synthetic conductance having linear state-change characteristics may be obtained. Because the synthesis conductance corresponds to a weight of a memory cell, the weight of the memory cell may be represented to be linearly updated.

Referring back to FIG. 5, different voltages applied to the ferroelectric memories 410, 420, 430, and 440 included in each of the plurality of memory cells 40 may be determined so that the nonlinear state characteristics of each ferroelectric memory may be offset in a process of synthesizing the conductances by parallel connection. As shown in FIG. 5, when DC voltages having a constant voltage interval are applied to output terminals of the sub-bit lines $SBL_{21}$, $SBL_{22}$, ..., and $SBL_{24}$, a corresponding voltage interval may be required to be properly set. Hereinafter, a method of determining voltages applied to output terminals of the sub-bit lines $SBL_{21}$, $SBL_{22}$, ..., and $SBL_{24}$ will be described in detail.

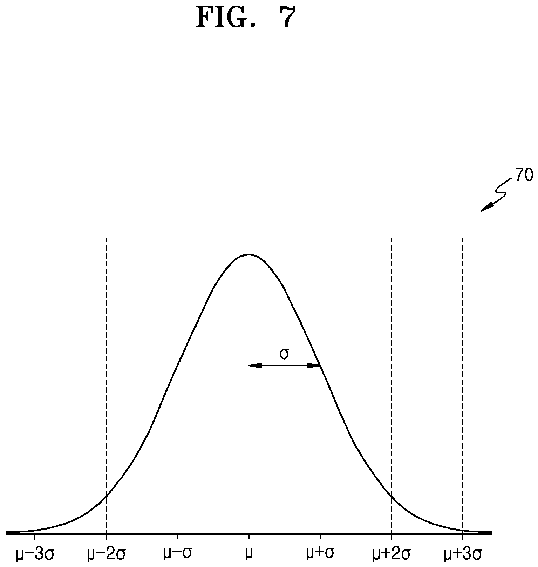

FIG. 7 is a view for describing a method for determining different voltages applied to ferroelectric memories included in each memory cell of a neural network device according to at least one embodiment.

Referring to FIG. 7, a graph 70 in which the positive voltage portion of the voltage-current characteristic curve 60 described with reference to FIG. 6 is approximated as a Gaussian distribution, is shown.

A difference (e.g., ΔV of FIG. 5) between DC voltages applied to output terminals of adjacent sub-bit lines (e.g., $SBL_{21}$ and $SBL_{22}$ of FIG. 5) among sub-bit lines (e.g., $SBL_{21}$, $SBL_{22}$, ..., and $SBL_{24}$ of FIG. 5) may correspond to a standard deviation (e.g., standard deviation σ of graph 70) of the Gaussian distribution when the voltage-current characteristic curve of the ferroelectric memory is approximated as the Gaussian distribution.

However, the example embodiments are not necessarily limited thereto, and different voltages applied to ferroelectric memories included in one memory cell may be determined by an arbitrary appropriate method when nonlinear state characteristics of each ferroelectric memory are offset in a process of synthesizing conductances by parallel connection. Different voltages applied to ferroelectric memories included in one memory cell may be differently set according to the number of ferroelectric memories included in one memory cell. Also, different voltages applied to the ferroelectric memories included in one memory cell may be differently set according to a minimum voltage and/or step size of a voltage (e.g., $V_{train}$ of FIG. 5) applied to an input terminal of a word line during training.

Also, in FIG. 5, DC voltages having a constant voltage interval are applied to output terminals of sub-bit lines. However, this is just an example. DC voltages having a constant voltage interval may not necessarily be required to be applied to output terminals of the sub-bit lines, and DC voltages having a voltage interval may also be applied as long as the nonlinear state-change characteristics of each ferroelectric memory are offset in a process of synthesizing conductances by parallel connection.

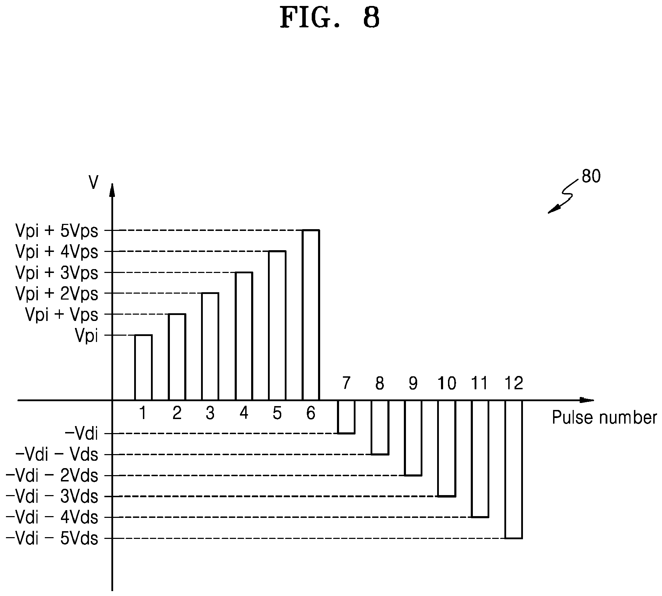

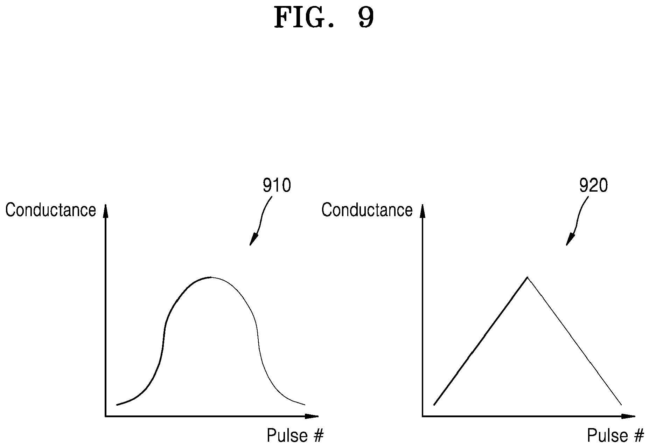

Hereinafter, an experimental design that may show that the nonlinear state-change characteristics of each ferroelectric memory may be offset in a process of synthesizing conductances by parallel connection will be described with reference to FIGS. 8 and 9.

FIG. 8 is a view for describing incremental step pulse Programming (ISPP) according to at least one embodiment.

A voltage (e.g., $V_{train}$ of FIG. 5) applied to an input terminal of a word line during training may have a shape of a pulse train shown in FIG. 8. For example, voltage applied to the input terminal of the word line during training may be a pulse voltage with a gradually increased magnitude. As shown in FIG. 8, a positive voltage pulse with a gradually increased magnitude may be applied from first through sixth cycles, and a negative voltage pulse with a gradually increased magnitude (e.g., an absolute value) may be applied from seventh through twelfth cycles.

In particular, a pulse increased by a voltage interval of $V_{ps}$ from the start of $V_{pi}$ may be applied from first through sixth cycles, and a pulse with an absolute value increased by a voltage interval of $V_{ds}$ from the start of $-V_{di}$ may be applied from seventh through twelfth cycles. $V_{pi}$ may be set greater than a minimum voltage for potentiation ferroelectric switching in the ferroelectric memory, and $V_{di}$ (e.g., an absolute value of $-V_{di}$) may be set greater than a minimum voltage for depression ferroelectric switching in the ferroelectric memory.

Because the ferroelectric memory has an asymmetric material structure, more energy may be required in the case where electric polarization is depressed than it is potentiated. Thus, $V_{ds}$ that is a voltage interval during depression may be greater than $V_{ps}$ that is a voltage interval during potentiation. However, embodiments are not necessarily limited thereto, and $V_{ds}$ and $V_{ps}$ may be properly set according to an experiment method. Also, an example in which the number of pulses is 12, is shown in FIG. 8. However, the number of pulses for ISPP may be greater than or less than 12.

When a voltage corresponding to FIG. 8 is applied to an input terminal of a word line and conductance characteristics of a memory cell by the applied voltage are measured, state-change characteristics (e.g., PD characteristics) of the memory cell may be obtained.

FIG. 9 is a view for comparing a PD characteristic curve of a single ferroelectric memory with a PD characteristic curve of a memory cell according to an embodiment.

Referring to FIG. 9, PD characteristic curves obtained by ISPP for applying the voltage corresponding to FIG. 8 are shown. A PD characteristic curve 910 represents PD characteristics of a single ferroelectric memory, and a PD characteristic curve 920 represents PD characteristics of a memory cell including a plurality of ferroelectric memories connected in parallel according to the present disclosure. The PD characteristic curve 910 represents bell-shaped long-term potentiation and depression (LTPD) characteristics, whereas the PD characteristic curve 920 represents linear LTPD characteristics.

In this way, the memory cell according to the present disclosure has linear characteristics with respect to voltage changes and thus, the synthesis conductance of the memory cell may be more precisely controlled. Further, as the synthesis conductance of the memory cell is precisely controlled, the distinctive steps of the weight corresponding to the synthesis conductance of the memory cell may be increased, and multi-value characteristics may be enhanced. When the multi-value characteristics are enhanced, a more elaborate neural network may be implemented.

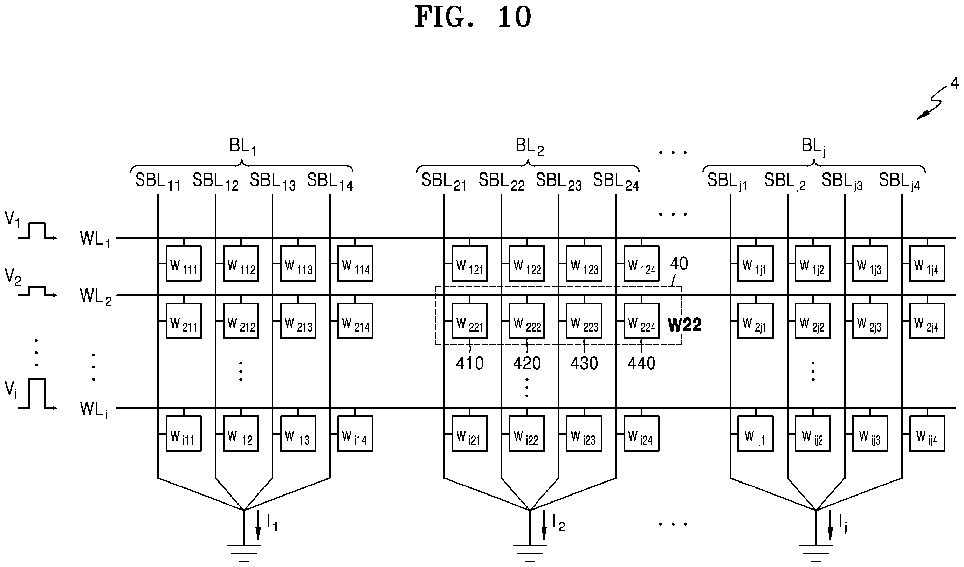

FIG. 10 is a view illustrating a circuit structure at the time of inference of a neural network device according to an embodiment.

Referring to FIG. 10, an example of a process of performing an inference of a neural network device 4 based on voltages $V_1$, $V_2$, ..., and $V_i$ input through a plurality of word lines $WL_1$, $WL_2$, ..., and $WL_i$ and weights stored in a plurality of memory cells 40, is shown. Voltages $V_1$, $V_2$, ..., and Vi input through a plurality of word lines $WL_1$, $WL_2$, ..., and $WL_i$ during an inference of the neural network may have voltage magnitudes at which ferroelectric switching of ferroelectric memories included in the plurality of memory cells 40 does not occur.

When the inference is performed using the trained neural network, the neural network device 4 may connect output terminals of sub-bit lines so that currents flowing through each of the sub-bit lines are summed and output. For example, as shown in FIG. 10, as the output terminals of the sub-bit lines $SBL_{21}$, $SBL_{22}$, ..., and $SBL_{24}$ are connected to the same ground voltage, a summation current $I_2$ may be output.

Because the plurality of memory cells 40 have conductances corresponding to weights and voltages $V_1$, $V_2$, ..., and $V_i$ input through the plurality of word lines $WL_1$, $WL_2$, ..., and $WL_i$ correspond to input activations, summation currents $I_1$, $I_2$, ..., and $I_j$ output through a plurality of bit lines $BL_1$, $BL_2$, ..., and $BL_j$ may correspond to the result of a neural network operation (e.g., a multiply-accumulate (MAC) operation) performed in an analog manner.

Also, the neural network device 4 may include a switching circuit (not shown) that controls output terminals of the sub-bit lines to be connected to each other or to be connected to DC voltages. For example, the neural network device 4 may control the switching circuit so that the output terminals of the sub-bit lines are connected to the DC voltages during training, as shown in FIG. 5. Also, the neural network device 4 may control the switching circuit so that the output terminals of the sub-bit lines are connected to each other during inference, as shown in FIG. 10. The switching circuit may include a multiplexer, a switch, and/or the like. However, embodiments are not limited thereto.

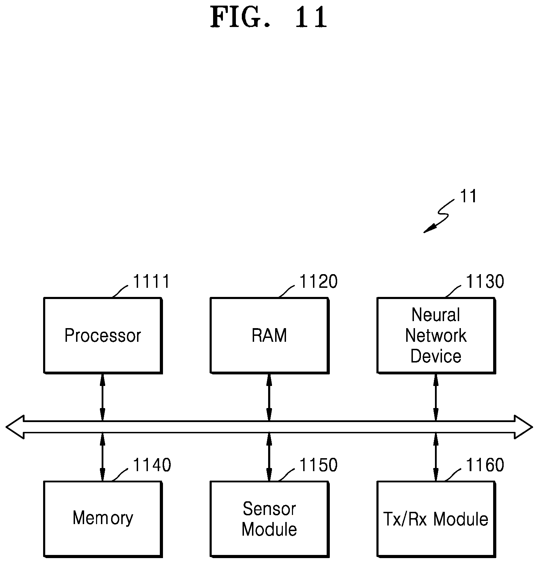

FIG. 11 is a block diagram illustrating a configuration of an electronic system according to at least one embodiment.

Referring to FIG. 11, an electronic system 11 may extract effective information by analyzing input data based on the neural network in real time and may perform situation determination based on the extracted information and/or may control configurations of an electronic device on which the electronic system 11 is mounted. For example, the electronic system 11 may be applied to a drone, a robot device such as an advanced drivers assistance system (ADAS), a smart television (TV), a smartphone, a medical device, a mobile device, an image display device, a measurement device, an Internet of Things (IoT) device, and/or the like, and/or may be mounted on at least one of various types of electronic devices.

The electronic system 11 may include a processor 1110, random access memory (RAM) 1120, a neural network device 1130, a memory 1140, a sensor module 1150, and a communication module 1160. The electronic system 11 may further include an input/output module, a security module, a power control device, and/or the like. Some of hardware configurations of the electronic system 11 may be mounted on at least one semiconductor chip.

The processor 1110 may control the overall operation of the electronic system 11. The processor 1110 may include one processor core Single Core and/or a plurality of processor cores Multi-Core. The processor 1110 may process and/or execute programs and/or data stored in the memory 1140. In some embodiments, the processor 1110 may execute the programs stored in the memory 1140, thereby controlling the function of the neural network device 1130. The processor 1110 may be implemented with (and/or include) at least one of a central processing unit (CPU), a graphics processing unit (GPU), an application processor (AP), and/or the like.

The RAM 1120 may be a non-transitory computer readable storage and may temporarily store programs, data, and/or instructions. For example, the programs and/or data stored in the memory 1140 may be temporarily stored in the RAM 1120 according to control and/or booting code of the processor 1110. The RAM 1120 may be implemented with memory such as dynamic RAM (DRAM) or static RAM (SRAM).

The neural network device 1130 may perform an operation of the neural network based on the received input data and may generate an information signal based on the result of performing. The neural network may include CNN, RNN, FNN, Deep Belief Networks, Restricted Boltzmann Machines, and/or the like but is not limited thereto. The neural network device 1130 may be (or include) a hardware accelerator dedicated to the neural network and/or a device including the same. The neural network device 1130 may perform an operation of reading and/or writing in addition to the operation of the neural network.

The neural network device 1130 may correspond to the neural network device 4 described with reference to FIGS. 4, 5, and 10. Because the neural network device 1130 may implement weights having linear statechange characteristics, the accuracy of the neural network operation performed by the neural network device 1130 may be increased, and a more elaborate neural network may be implemented.

The information signal may include one of a variety of recognition signals, such as speech recognition signals, object recognition signals, image recognition signals, biometric information recognition signals, and the like. For example, the neural network device 1130 may receive frame data included in a bitstream as input data and may generate recognition signals for an object included in an image represented by the frame data from the frame data. However, embodiments are not limited thereto, and the neural network device 1130 may receive various types of input data according to the type and/or function of the electronic device on which the electronic system 11 is mounted and may generate recognition signals according to the input data.

The memory 1140 is a storage place for storing data, and may store an operating system (OS), various types of programs, and various types of data. In an embodiment, the memory 1140 may store the intermediate results generated during the operation execution of the neural network device 1130.

The memory 1140 may be a non-transitory computer readable storage and may be, e.g., a DRAM. However, embodiments are not limited thereto. The memory 1140 may include at least one of volatile memory and nonvolatile memory. The nonvolatile memory may include read only memory (ROM), programmable ROM (PROM), electrically programmable ROM (EPROM), electrically erasable and programmable ROM (EEPROM), flash memory, phase-change RAM (PRAM), magnetic RAM (MRAM), resistive RAM (RRAM), ferroelectric RAM (FRAM), and/or the like. The volatile memory may include a DRAM, an SRAM, a synchronous DRAM (SDRAM), and/or the like. In an embodiment, the memory 1140 may include at least one of a hard disk drive (HDD), a solid-state drive (SSD), a compact flash (CF), secure digital (SD), micro secure digital (Micro-SD), mini secure digital (Mini-SD), and a memory stick.

The sensor module 1150 may collect information around the electronic device on which the electronic system 11 is mounted. The sensor module 1150 may sense and/or receive a signal (e.g., an image signal, a sound signal, a magnetic signal, a bio-signal, a touch signal, and/or the like) from an outside of the electronic device and may convert the sensed and/or received signal into data. To this end, the sensor module 1150 may include at least one of various types of sensing devices, such as a sensing device, e.g., a microphone, an image capturing device, an image sensor, a light detection and ranging (LIDAR) sensor, an ultrasonic sensor, an infrared ray sensor, a bio sensor, and a touch sensor.

In at least one embodiment, the sensor module 1150 may provide the converted data as input data to the neural network device 1130. For example, the sensor module 1150 may include an image sensor, may generate a video stream by capturing an external environment of the electronic device and may provide a consecutive data frame of the video stream to the neural network device 1130 as input data in order. However, embodiments are not limited thereto, and the sensor module 1150 may provide various types of data to the neural network device 1130.

The communication module 1160 may include wired and/or wireless interfaces that communicate with an external device through transmitting (Tx) and/or receiving (Rx) signals. For example, the communication module 1160 may include a local area network (LAN), a wireless local area network (WLAN) such as wireless fidelity (Wi-Fi), wireless personal area network (WPAN) such as Bluetooth, a wireless universal serial bus (USB), Zigbee, near field communication (NFC), radio-frequency identification (RFID), power line communication (PLC), a communication interface connectable to a mobile cellular network (such as 3rd generation (3G), 4th generation (4G), 5th generation (5G), long term evolution (LTE), and/or the like), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A neural network device comprising:

a plurality of word lines extending in a first direction;
a plurality of bit lines extending in a second direction intersecting the first direction; and
a plurality of memory cells at points where the plurality of word lines and the plurality of bit lines intersect,
wherein each of the plurality of memory cells comprises at least two ferroelectric memories connected in parallel along a corresponding word line of the plurality of word lines.

2. The neural network device of claim 1, wherein the plurality of memory cells is configured such that

synthesis conductance of the ferroelectric memories, included in each of the plurality of memory cells, corresponds to a weight stored in a corresponding one of the plurality of memory cells, and

the weight stored in each of the plurality of memory cells is linearly updatable.

3. The neural network device of claim 1 or 2, wherein the neural network device is configured to train a neural network implemented by the neural network device by applying different voltages to the ferroelectric memories included in each of the plurality of memory cells, in a process of updating a weight stored in each of the plurality of memory cells.

4. The neural network device of claim 3, wherein the different voltages applied to the ferroelectric memories included in each of the plurality of memory cells are determined so that nonlinear state-change characteristics of each ferroelectric memory are offset in a process of synthesizing conductances by parallel connection.

5. The neural network device of claim 3 or 4, wherein

each of the plurality of bit lines comprises sub-bit lines respectively connected to ferroelectric memories included in corresponding ones of the memory cells connected to each bit line, and the neural network device is configured to update the weights by applying direct current (DC) voltages, having a constant voltage interval, to output terminals of the sub-bit lines.

6. The neural network device of claim 5, wherein a difference between DC voltages applied to output terminals of adjacent sub-bit lines, among the sub-bit lines, corresponds to a standard deviation of a Gaussian distribution when a voltage-current characteristic curve of a ferroelectric memory is approximated to the Gaussian distribution.

7. The neural network device of any of claims 3 to 6, wherein

each of the plurality of bit lines comprises sub-bit lines respectively connected to ferroelectric memories included in corresponding ones of the memory cells connected to each bit line, and output terminals of the sub-bit lines are connected such that, for at least one of the plurality of bit lines, currents flowing through each of the sub-bit lines are summed and output when inference is performed using the trained neural network.

8. The neural network device of claim 7, further comprising:

a switching circuit configured to control whether the output terminals of the sub-bit lines are connected to each other or are connected to DC voltages.

9. The neural network device of any preceding claim, wherein each of the plurality of memory cells further comprises a selection element configured to selectively approach the ferroelectric memories included in each of the plurality of memory cells.

10. The neural network device of any preceding claim, wherein each of the at least two ferroelectric memories comprise at least one of a capacitor having a metal-ferroelectric-metal structure; a ferroelectric tunnel junction, FTJ, element; or a ferroelectric field-effect transistor, FeFET.

11. An electronic system comprising:

the neural network device of any preceding claim;
a non-transitory memory; and
a processor configured to control a function of the neural network device by executing programs stored in the memory,
wherein the neural network device is configured to perform a neural network operation, based on input data received from the processor, and to generate an information signal corresponding to the input data, based on a result of the neural network operation.

12. An electronic system comprising:

a neural network device according to any of claims 1 to 10;
non-transitory memory storing instructions; and
processing circuitry configured to control a function the neural network device by executing the instructions stored in the memory such that the electronic system trains a neural network implemented by the neural network device by applying different voltages to the ferroelectric memories included in each of the plurality of memory cells.

13. The electronic system of claim 12, wherein the electronic system is configured to determine the different voltages applied to the ferroelectric memories included in each of the plurality of memory cells such that nonlinear state-change characteristics of each ferroelectric memory are offset in a process of synthesizing conductances by parallel connection.

14. The electronic system of claim 12 or 13, wherein

the processing circuitry is configured to control voltage input to an input terminal of a word line, of the plurality of word lines, as a pulse train during the training of the neural network, and a state-change characteristic curve of each of the plurality of memory cells during the training of the neural network is represented by a linear long-term potentiation and depression characteristic, and optionally wherein the pulse train includes a first period of positive voltage pulses of increasing magnitude and a second period of negative voltages pulses of increasing magnitude.

15. The electronic system of claim 14, wherein

each of the plurality of bit lines comprises sub-bit lines respectively connected to ferroelectric memories included in corresponding ones of the memory cells connected to each bit line, and the training of the neural network further includes applying direct current, DC, voltages, having a constant voltage interval, to output terminals of the sub-bit lines, and optionally wherein a difference between DC voltages applied to output terminals of adjacent sub-bit lines, among the sub-bit lines, corresponds to a standard deviation of a Gaussian distribution when a voltage-current characteristic curve of a ferroelectric memory is approximated to the Gaussian distribution.

FIG. 1

# FIG. 2

# FIG. 3

# FIG. 4

EP 4 198 830 A1

# FIG. 5

EP 4 198 830 A1

# FIG. 6

# FIG. 7

# FIG. 8

# FIG. 9

# FIG. 10

EP 4 198 830 A1

# FIG. 11

11

| 1111 | 1120 | 1130 |
|------|------|------|
| Processor | RAM | Neural Network Device |

| 1140 | 1150 | 1160 |
|------|------|------|
| Memory | Sensor Module | Tx/Rx Module |

Europäisches
Patentamt

European
Patent Office

Office européen
des brevets

# EUROPEAN SEARCH REPORT

Application Number

EP 22 21 3165

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BOYBAT IREM ET AL: "Neuromorphic computing with multi-memristive synapses", NATURE COMMUNICATIONS, vol. 9, no. 1, 28 June 2018 (2018-06-28), XP093036075, DOI: 10.1038/s41467-018-04933-y | 1-3,7-9, 11,12 | INV. G06N3/065 |
| Y | * the whole document * | 4-6,10, 13-15 | |
| X | BERDAN R ET AL: "Low-power linear computation using nonlinear ferroelectric tunnel junction memristors", NATURE ELECTRONICS, vol. 3, no. 5, 1 May 2020 (2020-05-01), pages 259-266, XP055964432, DOI: 10.1038/s41928-020-0405-0 | 1-3,7-9, 11,12 | |
| Y | * the whole document * | 4-6,10, 13-15 | |
| A | BOYBAT IREM ET AL: "Neuromorphic computing with multi-memristive synapses: Supplementary information", NATURE COMMUNICATIONS, vol. 9, no. 1, 28 June 2018 (2018-06-28), XP093036087, * the whole document * | 1-15 | |
| A | US 2021/257405 A1 (LESSO JOHN PAUL [GB]) 19 August 2021 (2021-08-19) * the whole document * | 1-15 | |

TECHNICAL FIELDS SEARCHED (IPC)

G06N

-/--

The present search report has been drawn up for all claims

| Place of search | Date of completion of the search | Examiner |
|---|---|---|
| The Hague | 31 March 2023 | Jacobs, Jan-Pieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

**EP 22 21 3165**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HYONGSUK KIM ET AL: "Memristor Bridge Synapses", PROCEEDINGS OF THE IEEE, IEEE. NEW YORK, US, vol. 100, no. 6, 1 June 2012 (2012-06-01), pages 2061-2070, XP011443935, ISSN: 0018-9219, DOI: 10.1109/JPROC.2011.2166749 * the whole document * ----- | 1-15 | |

TECHNICAL FIELDS
SEARCHED      (IPC)

The present search report has been drawn up for all claims

| Place of search | Date of completion of the search | Examiner |
|---|---|---|
| The Hague | 31 March 2023 | Jacobs, Jan-Pieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................

& : member of the same patent family, corresponding document

EPO FORM 1503 03.82 (P04C01)

**page 2 of 2**

**EP 4 198 830 A1**

## ANNEX TO THE EUROPEAN SEARCH REPORT
## ON EUROPEAN PATENT APPLICATION NO.

EP 22 21 3165

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2023

| Patent document cited in search report | Publication date | Patent family member(s) | Publication date |
|---|---|---|---|
| US 2021257405 A1 | 19-08-2021 | US 2020251526 A1 | 06-08-2020 |
| | | US 2021257405 A1 | 19-08-2021 |

EPO FORM P0459

For more details about this annex : see Official Journal of the European Patent Office, No. 12/82